# EUROPEAN PATENT SPECIFICATION

(11) **EP 0 587 335 B1**
(45) Date of publication and mention of the grant of the patent: **19.12.2001**
(21) Application number: 93306617.7
(22) Date of filing: 20.08.1993
(51) Int. Cl.: H01L 21/316, H01L 21/3105, H01L 21/322, H01L 21/768

(54) **Planarization technique**
Planarisierungsverfahren
Procédé de planarisation

(30) Priority: 21.08.1992 US 934172
(43) Date of publication of application: 16.03.1994
(60) Divisional application: 01201322.3
(73) Proprietor: STMicroelectronics, Inc., Carrollton, TX 75006-5039 (US)
(72) Inventor: Chan, Tsiu Chiu, Dallas County, Texas 75006 (US); Bryant, Frank Randolph, Denton County, Texas 76201 (US)
(74) Representative: Palmer, Roger

(56) References cited:
- EP-A- 0 315 350
- EP-A- 0 437 933
- WO-A-91/12630
- WO-A-91/19316
- WO-A-91/19317
- WO-A-93/04501
- DIGEST OF THE 1990 SYMP. ON VLSI TECHNOLOGY, June 1990, HONOLULU pages 123 - 124 WONG ET AL 'Mobile ion gettering in passivated p+ polysilicon gates'
- JOURNAL OF THE ELECTROCHEMICAL SOCIETY, vol.137, no.1, January 1990, MANCHESTER, NEW HAMPSHIRE US pages 229 - 234 SMOLINSKY ET AL 'Material properties of spin-on silicon oxide (SOX) for fully recessed NMOS field isolation'
- NICOLLIAN ET AL: "MOS (Metal Oxide Semiconductor) Physics and Technology, pages770-771", 1982, JOHN WILEY & SONS, NEW YORK, USA

## Description

The present invention relates generally to semiconductor integrated circuit processing, and more specifically to a planarization technique suitable for use in the submicron technology.

The manufacturing costs of integrated circuits are largely dependent upon the chip area required to implement desired functions. The chip area, in turn, is defined by the geometries and sizes of the active components such as gate electrodes in metal-oxide-semiconductor (MOS) technology, and diffused regions such as MOS source and drain regions and bipolar emitters and base regions. These geometries and sizes are often dependent upon the photolithographic resolution available for the particular manufacturing facility. The goal of photolithography in establishing the horizontal dimensions of the various devices and circuits is to create a pattern which meets design requirements as well as to correctly align the circuit pattern on the surface of the wafer. As line widths shrink smaller and smaller in submicron photolithography, the process to print lines and contact holes in photoresist becomes increasingly more difficult.

With circuit advancement to the very-large-scale integration (VLSI) levels, more and more layers are added to the surface of the wafer. These additional layers in turn create more steps on the wafer surface. The resolution of small image sizes in photolithography thus becomes more difficult over the additional steps due to light reflection and the thinning of the photoresists over the steps. Planarization techniques are generally incorporated to offset the effects of a varied topography.

Many different planarization techniques have been used in the past, each with its own disadvantages. Multilayer photoresist processes have been used to create the desired images. The particular photoresist process depends upon the severity of the topography and the size of the desired images. These processes however, take longer and require more yield-limiting steps. Polyimides and reflow glass layers are used to planarize the surface of the wafer. Polyimides can be spun onto the wafer like the photoresist materials. After application, the polyimide is covered with a hard layer and patterned like the photoresists. Reflow glass layers are generally doped with boron or phosphorous or both to lower the temperature at which the glass layer will flow. While these layers achieve more planarization than previous methods, additional planarization is still required as the device geometries continue to shrink.

WO-A-91-19,317 discloses a method of applying spin-on glass over low-melting point, non-refractory metals such as aluminium. The applied spin-on glass is subjected to outgassing of water and capped with a protective dielectric layer resistant to moisture diffusion. The phosphorus alloyed spin-on-glass, when dry, is ready for gettering.

WO-A-91-19,316 discloses a method of applying spin-on glass over low-melting point, non-refractory materials such as aluminium. The spin-on glass is applied in a moisture-free environment to minimise reverse hydrolysis.

Digest of the 1990 Symp. on VLSI Technology, pages 123 to 124 discloses the use of BPSG and PSG films as mobile ion getterers.

Journal of the Electrochemical Society, Vol. 137, No 1, pages 229 to 234, discloses the multiple application of layers of boron doped spin-on glass to fill trenches provided for MOS field isolation.

Spin-on-glass (SOG) is also a hard planarizing layer which is a mixture of silicon dioxide in a solvent that quickly evaporates. There may be carbon in the SOG to reduce the SOG's susceptibility to cracking after it is baked. SOG, by itself, however, is unable to prevent mobile ionic contaminants from travelling through the layer and into the devices or wafer surface below the SOG.

It is therefore an object of this invention to provide a method of forming a planarizing layer which is capable of preventing mobile ionic contaminants from traveling through the planarizing layer and into the underlying layers.

It is a further object of this invention to provide such a method which utilizes a doped spin-on-glass insulating layer.

It is a further object of this invention to provide such a method which utilizes conventional process flows.

Other objects and advantages of the invention will be apparent to those of ordinary skill in the art having reference to the following specification together with the drawings.

According to a first aspect of the present invention there is provided a method of forming a planar surface of a semiconductor integrated circuit; comprising the steps of:
forming a conductive structure on the integrated circuit;
forming an insulating layer over the conductive structure and a portion of the integrated circuit not covered by the conductive structure; and
forming a first planar spin-on-glass layer having a thickness between 200 to 800 nm (2000 to 8000 Angstroms) over the insulating layer,
wherein the spin-on-glass is doped to a concentration between 4 to 7 percent to facilitate gettering of charge mobile ions, curring the doped spin-on-glass layer during a ramp up in temperature to between 500°C and 800°C, and forming an opening in the spin-on-glass and the insulating layer exposing a portion of the conductive structure.

According to one embodiment of the present invention: the conductive structure may comprise a transistor gate having a gate electrode and a source/drain region adjacent to the gate electrode and in a substrate underlying the gate electrode; the insulating layer may be silicon dioxide; and an opening may be formed in the spin-on-glass layer and the silicon dioxide layer to expose a portion of the source/drain region.

The invention may be incorporated into a method for forming a semiconductor device structure. A conductive structure is formed on the integrated circuit such as a gate electrode having source/drain regions in the substrate. An insulating layer, such as silicon dioxide, is formed over the conductive structure and a portion of the integrated circuit not covered by the conductive structure. A planar doped spin-on-glass layer is then formed over the insulating layer, wherein the spin-on-glass is doped to a concentration sufficient to allow gettering of charge mobile ions.

The novel features believed characteristic of the invention are set forth in the appended claims. The invention itself, however, as well as a preferred mode of use, and further objects and advantages thereof, will best be understood by reference to the following detailed description of illustrative embodiments when read in conjunction with the accompanying drawings, wherein:

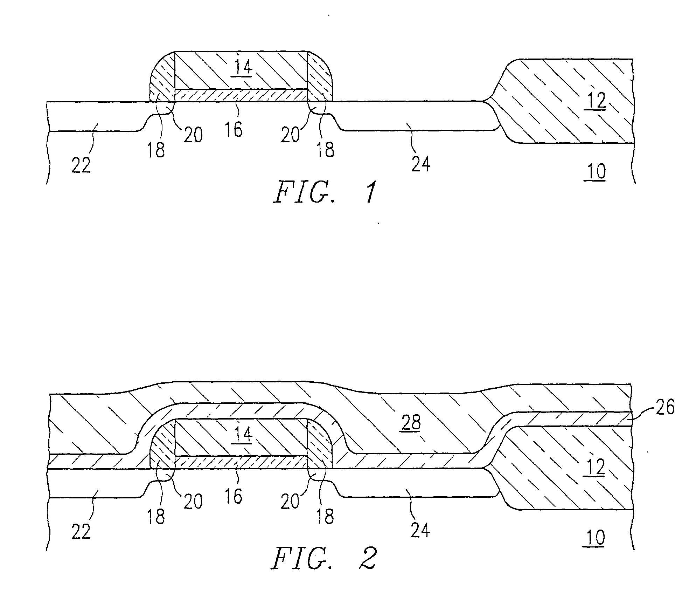

**Figures 1-2** are cross sectional views of the fabrication of a semiconductor integrated circuit according to the present invention.

The process steps and structures described below do not form a complete process flow for manufacturing integrated circuits. The present invention can be practiced in conjunction with integrated circuit fabrication techniques currently used in the art, and only so much of the commonly practiced process steps are included as are necessary for an understanding of the present invention. The figures representing cross-sections of portions of an integrated circuit during fabrication are not drawn to scale, but instead are drawn so as to illustrate the important features of the invention.

Referring to **Figure 1**, an integrated circuit is to be formed on a silicon substrate 10. A field oxide region 12 is formed in an area on the substrate as known in the art to separate active areas. A conductive structure such as a transistor is formed over a portion of the substrate 10. The transistor comprises gate electrode 14, preferably a doped polysilicon, which is formed over a gate oxide 16 as known in the art. The transistor typically also comprises oxide spacers 18 formed adjacent to the gate oxide 16 and gate electrode 14. Lightly doped source and drain regions 20 and heavily doped source and drain regions 22, 24 are formed in the substrate adjacent to the gate electrode, also by conventional methods.

Referring to **Figure 2**, an insulating layer 26, such as silicon dioxide is formed over a portion of the integrated circuit including the conductive structure. The silicon dioxide layer 26 is formed to prevent counterdoping between, for example, the source/drain regions 22, 24 and overlying layers subsequently formed. Layer 26 typically has a thickness of between approximately 10 to 200 nm (100 to 2000 angstroms). Layer 26 may also be lightly doped to improve its protective and flow characteristics, for example with phosphorus.

A planar spin-on-glass layer 28 is then deposited over the insulating layer 26 to a depth of between approximately 200 to 800 nm (2000 to 8000 angstroms). The difference between the prior art and the present invention is that the SOG is now doped in the present invention, preferably with phosphorous, to a concentration sufficient to allow gettering of charge mobile ions. The dopant concentration is between 4 to 7 percent. For example, sodium molecules will not move through the SOG and penetrate the silicon dioxide layer 26 and silicon substrate 10. Instead, the contaminating ions will attach to the phosphorous in the SOG and be prevented from changing device characteristics. The SOG layer 28 is cured to increase the layer's protective characteristics. The SOG is preferably cured at or below atmospheric pressure to enhance solvent outgassing. In addition, the temperature at which the SOG is cured will ramped up to between approximately 500 to 800° C. For example, the temperature may begin at a lower temperature to drive out the solvent molecules and be increased to a higher temperature to densify the SOG. The doped SOG thus will planarize the surface of the wafer before a contact opening is formed while preventing contaminating ions from moving through the layer. The doped SOG will be particularly useful in the submicron regime where device size is decreasing and device performance is critical.

Alternatively, an etchback of the SOG layer 28 may be done before or after the curing process. A second layer of SOG may be formed to further planarize the surface of the wafer. The second layer, if formed, may also be doped and cured. Other uses of the doped SOG layer will become apparent to those skilled in the art. For example, the doped SOG layer may be formed between different polysilicon layers. Again, the doped SOG will planarize the surface of the wafer and allow gettering of the charge mobile ions.

## Claims

1. A method of forming a planar surface on a semiconductor integrated circuit structure, comprising the steps of:
forming a conductive structure on the integrated circuit structure;
forming an insulating layer (26) over the conductive structure and a portion of the integrated circuit structure not covered by the conductive structure;
forming a planarizing layer over the insulating layer (26) by applying a first planar spin-on-glass layer (28) having a thickness between 200 to 800 nanometres (2000 to 8000 Angstroms) over the insulating layer (26), wherein the spin-on-glass (28) is doped to a concentration of between 4 to 7 percent to facilitate gettering of charge mobile ions;
curing the doped spin-on-glass layer during a ramp up in temperature to between 500°C and 800°C; and
forming an opening in the spin-on-glass layer and the insulating layer exposing a portion of the conductive structure.

2. The method of claim 1, wherein the conductive structure comprises a transistor gate having a gate electrode (14), and a source/drain region (22,24) adjacent to the gate electrode (14) and in a substrate (10) underlying the gate electrode.

3. The method of claim 2 wherein the gate electrode is formed of doped polysilicon.

4. The method of claim 1 wherein the first spin-on-glass layer (28) is cured at or below atmospheric pressure to enhance solvent outgassing.

5. The method of claim 1, further comprising the steps of:
performing a partial etchback of the first spin-on-glass layer(28); and
forming a second planar spin-on-glass layer (28) over the first spin-on-glass layer (28), wherein the second spin-on-glass layer is doped to facilitate gettering of charge mobile ions.

6. The method of nay preceding claim wherein the insulating layer (26) is a layer of silicon dioxide.

7. The method of claim 6 when dependent upon claim 2; wherein the step of forming an opening in the spin-on-glass layer (28) and the silicon dioxide layer (26) exposes a portion of the source/drain region (22,24).

8. The method of claim 6 wherein the silicon dioxide is doped.

9. The method of claim 8 wherein the silicon dioxide is doped with phosphorus.

10. The method of claim 7 or 8 wherein the silicon dioxide layer is between 10 to 200 nanometres (100 to 2000 angstroms).

## Patentansprüche

1. Verfahren zur Ausbildung einer planaren Oberfläche auf einer integrierten Halbleiterschaltungsstruktur mit den Schritten:
Ausbilden einer leitfähigen Struktur auf der integrierten Schaltungsstruktur;
Ausbilden einer isolierenden Schicht (26) über der leitfähigen Struktur und einem Teil der integrierten Schaltungsstruktur, welcher nicht von der leitfähigen Struktur bedeckt ist;
Ausbilden einer Planarisierungsschicht über der isolierenden Schicht (26) durch Auftragen einer ersten planaren aufgeschleuderten Glas- bzw. spin-on-glass Schicht (28) mit einer Dicke zwischen 200 und 800 Nanometern (2000 bis 8000 Angström) über der isolierenden Schicht (26), wobei das aufgeschleuderte Glas- bzw. spin-on-glass (28) dotiert ist mit einer Konzentration von zwischen 4 und 7%, um das Einfangen bzw. gettering von geladenen beweglichen Ionen zu ermöglichen;
Aushärten der dotierten aufgeschleuderten Glas- bzw. spin-on-glass Schicht während einem Hochlaufen (ramp up) der Temperatur auf zwischen 500°C und 800°C; und
Ausbilden einer Öffnung in der aufgeschleuderten Glas- bzw. spin-on-glass Schicht und der isolierenden Schicht und Freilegen eines Teils der leitfähigen Struktur.

2. Verfahren nach Anspruch 1, wobei die leitfähige Struktur umfasst: ein Transistor-Gate mit einer Gate-Elektrode (14) und einen Source/Drain-Bereich (22, 24), welcher benachbart zu der Gate-Elektrode (14) und in einem Substrat (10), welches unter der Gate-Elektrode liegt ist.

3. Verfahren nach Anspruch 2, wobei die Gate-Elektrode aus dotiertem Polysilizium gebildet wird.

4. Verfahren nach Anspruch 1, wobei die erste aufgeschleuderte Glas- bzw. spin-on-glass Schicht (28) ausgehärtet wird bei oder unterhalb atmosphärischem Druck, um die Ausgasung des Lösungsmittels zu fördern.

5. Verfahren nach Anspruch 1 weiter aufweisend die Schritte:
Durchführen eines teilweisen Rückätzens der ersten aufgeschleuderten Glassschicht (28); und
Ausbilden einer zweiten planaren aufgeschleuderten Glassschicht (28) über der ersten aufgeschleuderten Glassschicht (28), wobei die zweite aufgeschleuderte Glassschicht dotiert ist, um das Einfangen bzw. gettering von geladenen beweglichen Ionen zu ermöglichen.

6. Verfahren nach einem der vorhergehenden Ansprüche, wobei die isolierende Schicht (26) eine Schicht aus Siliziumdioxid ist.

7. Verfahren nach Anspruch 6, wenn von Anspruch 2 abhängig, wobei der Schritt der Ausbildung einer Öffnung in der aufgeschleuderten Glassschicht (28) und der Siliziumdioxid-Schicht (26) einen Teil des Source/Drain-Bereiches (22, 24) freilegt.

8. Verfahren nach Anspruch 6, wobei das Siliziumdioxid dotiert ist bzw. wird.

9. Verfahren nach Anspruch 8, wobei das Siliziumdioxid mit Phosphor dotiert ist bzw. wird.

10. Verfahren nach Anspruch 7 oder 8, wobei die Siliziumdioxid-Schicht zwischen 10 und 200 Nanometern (100 bis 2.000 Angström) ist.

## Revendications

1. Procédé pour former une surface plane sur une structure de circuit intégré à semiconducteurs, comprenant les étapes suivantes :
la formation d'une structure conductrice sur la structure de circuit intégré ;
la formation d'une couche isolante (26) sur la structure conductrice et une partie de la structure du circuit intégré non recouverte par la structure conductrice ;
la formation d'une couche d'aplanissement sur la couche isolante (26) en appliquant une première couche de verre centrifugé plane (28) ayant une épaisseur comprise entre 200 et 800 nanomètres (entre 2000 et 8000 Å) sur la couche isolante (26), le verre centrifugé (28) étant dopé à une concentration comprise entre 4 et 7 % pour faciliter le piégeage des gaz d'ions de charge mobiles ;
le durcissage de la couche de verre centrifugé dopée durant une montée en température en rampe entre 500° C et 800° C ; et
la formation d'une ouverture dans la couche de verre centrifugé et la couche isolante, exposant une partie de la structure conductrice.

2. Procédé selon la revendication 1, dans lequel la structure conductrice comprend une grille de transistor comportant une électrode de grille (14), et une région de source/drain (22, 24) adjacente à l'électrode de grille (14), et dans un substrat (10) sous-jacent à l'électrode de grille.

3. Procédé selon la revendication 2, dans lequel l'électrode de grille est formée de polysilicium dopé.

4. Procédé selon la revendication 1, dans lequel la première couche de verre centrifugé (28) est durcie à la pression atmosphérique ou en dessous de celle-ci pour améliorer le dégazage des solvants.

5. Procédé selon la revendication 1, comprenant de plus les étapes suivantes :
la réalisation d'une regravure partielle de la première couche de verre centrifugé (28) ; et
la formation d'une deuxième couche de verre centrifugé plane (28) sur la première couche de verre centrifugé (28), la deuxième couche de verre centrifugé étant dopée de façon à faciliter le piégeage de gaz d'ions de charge mobiles.

6. Procédé selon l'une quelconque des revendications précédentes, dans lequel la couche isolante (26) est une couche de dioxyde de silicium.

7. Procédé selon la revendication 6 lorsqu'elle dépend de la revendication 2, dans lequel l'étape de formation d'une ouverture dans la couche de verre centrifugé (28) et la couche de dioxyde de silicium (26) expose une partie de la région de source/drain (22, 24).

8. Procédé selon la revendication 6, dans lequel le dioxyde de silicium est dopé.

9. Procédé selon la revendication 8, dans lequel le dioxyde de silicium est dopé au phosphore.

10. Procédé selon la revendication 7 ou 8, dans lequel la couche de dioxyde de silicium a une épaisseur comprise entre 10 et 200 nanomètres (entre 100 et 2000 Å).
